Europäisches Patentamt

European Patent Office

Office européen des brevets

(11) Publication number: **0 273 100**
**A2**

## EUROPEAN PATENT APPLICATION

(21) Application number: **87110771.0**

(22) Date of filing: **24.07.87**

(51) Int. Cl.⁴: **H03H 17/06**

(30) Priority: **29.12.86 JP 309587/86**

(43) Date of publication of application:
**06.07.88 Bulletin 88/27**

(84) Designated Contracting States:
**DE FR GB**

(71) Applicant: **NEC HOME ELECTRONICS LTD.**
**8-17, Umeda, 1-chome Kita-Ku**
**Osaka-Shi Osaka(JP)**

(72) Inventor: **Kumasaka, Toru NEC Home**
**Electronics Ltd.**
**No. 8-17, Umeda 1-chome Kita-ku**
**Osaka-shi Osaka(JP)**

(74) Representative: **Diehl, Hermann, Dr.**
**Dipl.-Phys. et al**
**Diehl, Glaeser, Hiltl & Partner**
**Flüggenstrasse 13**
**D-8000 München 19(DE)**

(54) **Digital filter circuit.**

(57) A plurality of digital filters, each operating at mutually different clock frequencies, are cascaded to each other in a digital filter circuit. The clock frequencies are set so that the least common multiple thereof is equal to a high frequency at and above which the high-frequency component of a signal to be filtered by the digital filter circuit barely exists. By setting the clock frequencies in this manner, the second frequency pass band of the digital filter circuit can be raised to a high frequency so as to approximate the total filtering property of the digital filter circuit to that of a desired low-pass filtering property.

FIG. 2

EP 0 273 100 A2

## DIGITAL FILTER CIRCUIT

The present invention relates to a digital filter circuit and more particularly to cascaded digital filters which operate at mutually different clock frequencies.

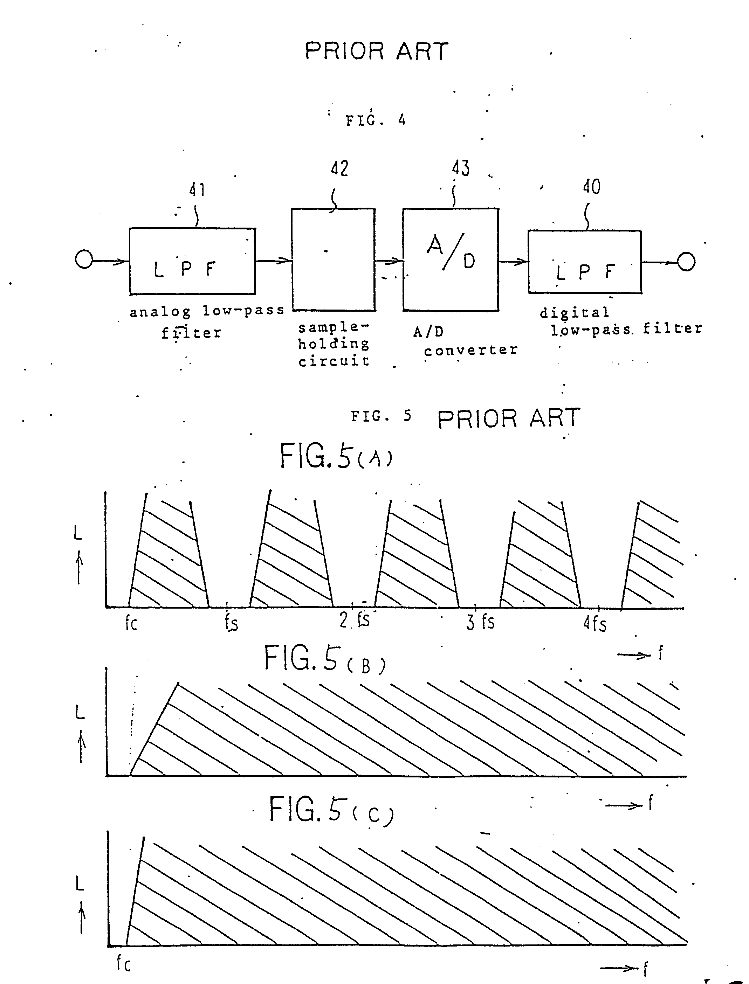

A conventional digital filter circuit may be used for signal processing circuits such as audio circuits, video circuits and control circuits. In a typical digital low-pass filter circuit for an audio circuit, for example, an analog low-pass filter 41, a sample-holding circuit 42 and an A/D converter 43 are provided in a front stage, whereas a digital low-pass filter 40 is provided in a rear stage, as shown in FIG. 4. In such a circuit, the analog low-pass filter 41 provided in front of the sample-holding circuit 42 removes a signal component whose frequency is higher than half of the sampling frequency so as to prevent aliasing.

In the digital low-pass filter circuit of FIG. 4, signal pass bands generally arise recurrently around the integer multiples of sampling frequency fs as shown in FIG. 5(A). As shown, the axis of the abscissa and the axis of the ordinate indicate the frequency f and the attenuated quantity L, respectively. Due to this characteristic, a desired low-pass filtering property generally cannot be achieved using only the digital low-pass filter 40. However, in the circuit arrangement of FIG. 4, a low-pass filtering property as shown in FIG. 5(B) may be superposed with the analog low-pass filter 41 and provided in front of the sample-holding circuit 42 to prevent aliasing. As a result, the desired low-pass filtering property shown in FIG. 5(C) is achieved.

In the digital low-pass filter circuit shown in FIG. 4, the desired low-pass filtering property is thus achieved through the inclusion of the analog low-pass filter 41 in front of the sample-holding circuit 42 for the prevention of aliasing. However, if a signal to be filtered by the circuit of FIG. 4 is an intermittent signal supplied from a rotary encoder or the like, there is no opportunity to transmit the signal through the analog low-pass filter 41 because the signal corresponds to an already sampled pseudo-digital signal. Consequently, the signal pass bands recurrently arise around higher frequencies as shown in FIG. 5(A) so that the desired low-pass filtering property cannot be achieved for the intermittent signal.

According to the present invention, a digital filter circuit is disclosed which includes a plurality of digital filters which operate at mutually different clock frequencies and which are cascaded to each other. The clock frequencies are set so that the least common multiple thereof is equal to a high frequency at and above which the high-frequency component of a signal to be filtered by the digital filter circuit barely exists.

The total frequency property of the cascaded digital filters is such that a second pass band of the frequency next higher than that of a first pass band for the DC component and so forth arises around the least common multiple of the clock frequencies. The relationship between the clock frequencies is adjusted to raise the second pass band to the high frequency at the end of the pass band at which the high-frequency component of the signal barely exists so that the desired low-pass filtering property is thus achieved.

FIG. 1 shows a block diagram of the constitution of an embodiment of the present invention as a digital low-pass filter circuit;

FIG. 2 shows a block diagram of the constitution of first digital low-pass filter 11 of FIG. 1;

FIGS. 3(A)-3(C) show filtering outputs of the circuit of FIG. 2 for describing the function of the digital low-pass filter circuit;

FIG. 4 shows a block diagram of a conventional digital low-pass filter circuit in connection with an analog low-pass filter circuit; and

FIGS. 5(A)-5(C) show filtering outputs of the prior art circuit of FIG. 4 for describing the function of the conventional digital low-pass filter circuit.

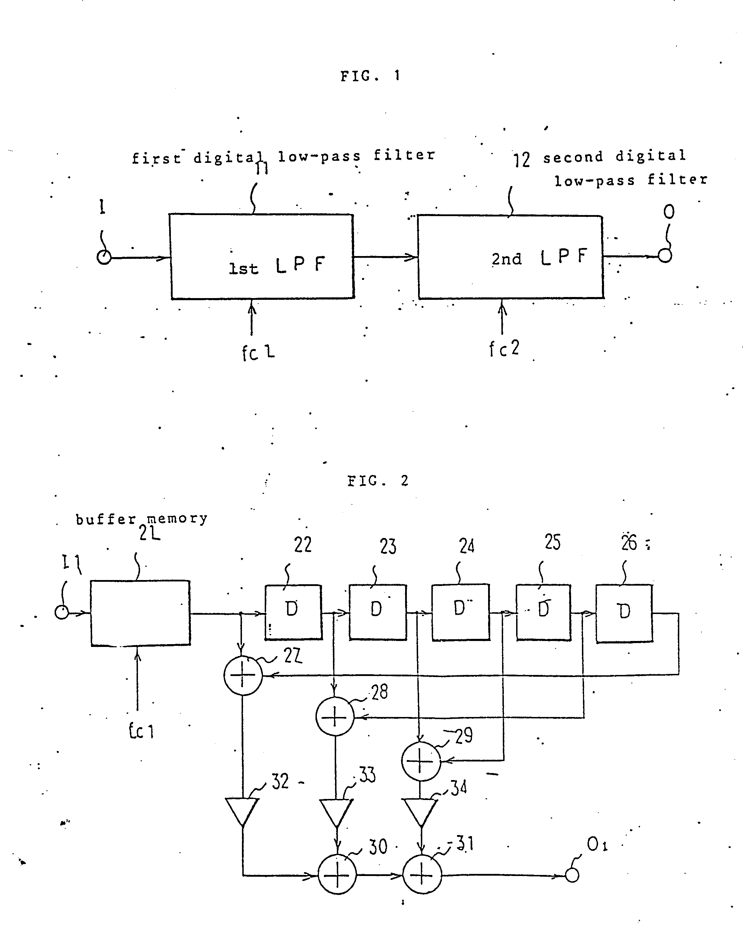

FIG. 1 shows a block diagram of the constitution of a digital low-pass filter circuit of an embodiment of the present invention. The circuit comprises a first digital low-pass filter 11 and a second digital low-pass filter 12 which are cascaded to each other between an input terminal I and an output terminal O. The first and the second digital low-pass filters 11 and 12 operate at different first and second clock frequencies $fc_1$ and $fc_2$, respectively.

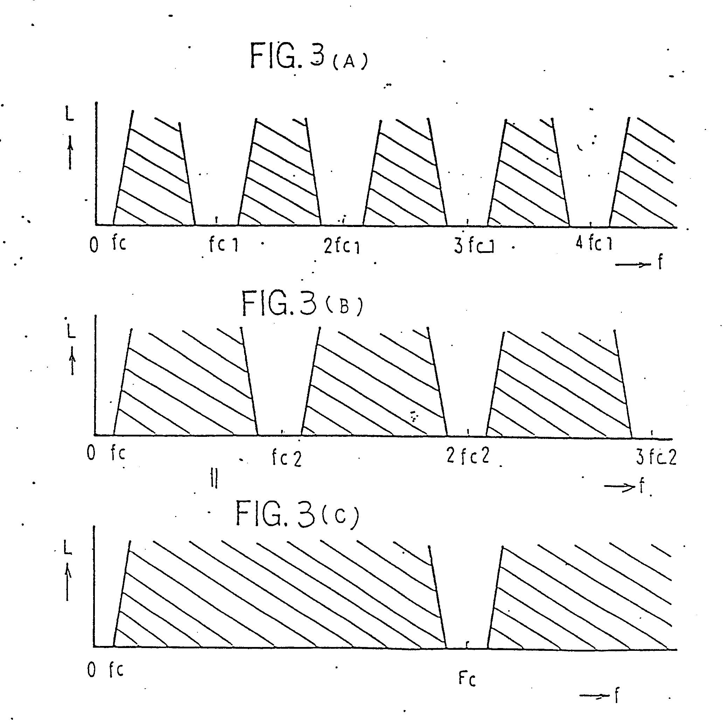

The first digital low-pass filter 11 comprises a buffer memory 21, one-clock-pulse delay circuits 22, 23, 24, 25 and 26, adders 27, 28, 29, 30 and 31, and coefficient means 32, 33 and 34, as shown by a block diagram in FIG. 2. The second digital low-pass filter 12 has the same constitution as the first digital low-pass filter 11 shown in FIG. 2 except that the second clock frequency $fc_2$ is used instead of the first clock frequency $fc_1$ for reading out the signal from the buffer memory and that the number of delay circuits and the coefficients of the coefficient means are different.

A digital signal, which intermittently appears on input terminal $I_1$ shown in FIG. 2 and which is to be subjected to low-pass filtering, is retained in place of an immediately preceding digital signal which was retained in the buffer memory 21. The digital signal retained in the buffer memory 21 is then repeatedly read out at the first clock frequency $fc_1$

so that the low-frequency component of the signal may be taken out through a digital low-pass filter section comprising the five cascaded one-clock-pulse delay circuits 22, 23, 24, 25 and 26, the adders 27, 28 and 29 for adding the delayed signals to each other, the coefficient means 32, 33 and 34 for multiplying the addition outputs of the adders by predetermined coefficients, and adders 30 and 31 for adding the outputs of the coefficient means to each other. The output of this digital low-pass filter section is then sent out from adder 31 via an output terminal $O_1$.

The filtering property of the first digital low-pass filter 11 is such that frequency pass bands recurrently arise around the integer multiples of the first clock frequency $fc_1$, as shown in FIG. 3(A). The axis of the abscissa and the axis of the ordinate indicate the frequency f and the attenuated quantity L, respectively. For purposes of illustration, the clock frequency $fc_2$ for the second digital low-pass filter 12, on the other hand, may be set to be equal to one and a half times the clock frequency $fc_1$ for the first digital low-pass filter 11. As a result, the filtering property of the second digital low-pass filter 12 is such that frequency pass bands recurrently arise around the integer multiples of the second clock frequency $fc_2$, as shown in FIG. 3(B).

The total filtering property of the digital low-pass filter circuit shown in FIG. 1 and comprising the first and the second digital low-pass filters 11 and 12 cascaded to each other consists of the superposition of the filtering properties of both the digital low-pass filters 11 and 12, as shown in FIG. 3(C). As can be seen in FIG. 3(c), the total filtering property is comprised of a second frequency pass band, the frequency of which is the lowest except for that of the first frequency pass band for the DC component and so forth, and it arises around the least common multiple $Fc = 3fc_1 = 2fc_2$ (for $fc_2 = 1.5 fc_1$) of both the clock frequencies $fc_1$ and $fc_2$. Therefore, the relationship between the first and the second clock frequencies $fc_1$ and $fc_2$ can be adjusted in order to raise the second frequency pass band to a high frequency at and above which the high-frequency component of the signal to be filtered by the digital low-pass filter circuit barely exists. In other words, the total filtering property can be approximated to that of a desired low-pass filtering property by raising the second frequency pass band by a necessary quantity to the desired cutoff frequency for the pass band.

By way of example, assume the first and the second clock frequencies $fc_1$ and $fc_2$ are set at 1 kHz and 1.3 kHz, respectively. The second frequency pass band would then be raised to a high frequency of 13 kHz. Thus, the total filtering property can be approximated by setting the desired low-pass filtering cutoff (frequency multiple) by selecting the different clock frequencies to be of the necessary frequencies.

Although two digital low-pass filters are cascaded to each other in the above-described embodiment, another appropriate number (three or more) of digital low-pass filters may be cascaded to each other if necessary. In addition, although the above-described embodiment is a digital low-pass filter circuit, the present invention is not confined thereto, for it may be embodied as a digital band pass filter circuit, a band stop filter circuit or the like. Also, since every high-pass filter circuit does not have an infinitely high frequency pass band in reality, the circuit of the present invention substantially has a band pass filtering property. Consequently, the present invention can also be embodied as a high-pass filter circuit which substantially has a band pass filtering property.

Although only a few exemplary embodiments of this invention have been described in detail above, those skilled in the art will readily appreciate that many modifications are possible in the preferred embodiments without materially departing from the novel teachings and advantages of this invention. Accordingly, all such modifications are intended to be included in this invention as defined by the following claims.

## Claims

1. A digital filter circuit comprising a plurality of digital filters (11, 12 ...) cascaded to each other between an input (I) and an output terminal (0), each of said digital filters operating at mutually different clock frequencies ($fc_1$, $fc_2$...), said frequencies being selected so that the least common multiple thereof is equal to a high-frequency representing the upper end of a desired passband.

2. A digital filter circuit as in claim 1, wherein each of said digital filters (11, 12) includes a buffer memory (21), a plurality of delay circuits (22, 23, 24, 25, 26) connected in series to said buffer memory (21), first adding means (27, 28, 29) for adding outputs of said delay circuits, coefficient means (32, 33, 34) for multiplying outputs of said adding means (27, 28, 29) by predetermined coefficients, and second adding means (30, 31), for adding outputs of said coefficient means (32, 33, 34),the output of said second adding means (30, 31) being supplied as an input to the next cascaded digital filter (11, 12).

3. A digital filter circuit as in claim 2, wherein the clock frequency for each respective digital filter (11, 12) is applied to the buffer memory (21) of each respective digital filter (11, 12) for reading out an input signal previously stored in the buffer memory (21).

4. A digital filter circuit as in one of the preceding claims wherein the digital filter (11, 12) is a digital low-pass filter.

FIG. 1

first digital low-pass filter  11    12 second digital low-pass filter

1

1st L P F    →    2nd L P F    0

fc1    fc2

FIG. 2

buffer memory
21

I1

fc1

22   23   24   25   26

D   D   D   D   D

27

28

29

32   33   34

30   31   O1

# FIG. 3 (A)

# FIG. 3 (B)

# FIG. 3 (C)

PRIOR ART

FIG. 4

41    42    43    40

○ →    L P F    →    [sample-holding]    →    A/D    →    L P F    → ○

analog low-pass
filter

sample-
holding
circuit

A/D
converter

digital
low-pass filter

FIG. 5    PRIOR ART

FIG.5(A)

FIG.5(B)

FIG.5(C)